# EUROPEAN PATENT APPLICATION

(11) **EP 1 432 117 A1**
(43) Date of publication of application: **23.06.2004**
(21) Application number: 02768069.3
(22) Date of filing: 25.09.2002
(51) Int. Cl.: H03B 5/12, H03B 19/14, H03B 27/00, H04L 27/00

(54) **OSCILLATOR, TRANSMISSION CIRCUIT, AND RADIO APPARATUS**

(30) Priority: 27.09.2001 JP 2001296857
(71) Applicant: MATSUSHITA ELECTRIC INDUSTRIAL CO., LTD., Kadoma-shi, Osaka 571-8501 (JP)
(72) Inventor: SAITO, Noriaki, Machida-shi, Tokyo 194-0014 (JP); SHIMIZU, Yoshito, Kawasaki-shi, Kanagawa 215-0005 (JP); YABUKI, Hiroyuki, Kawasaki-shi, Kanagawa 214-0014 (JP)
(74) Representative: Grünecker, Kinkeldey, Stockmair & Schwanhäusser Anwaltssozietät
(86) International application number: PCT/JP2002/009886
(87) International publication number: WO 2003/030350

(57) **Abstract**

In a cross type oscillator (20) comprising spiral inductors (L1, L2) andresonance capacitors (C1, C2) which decide resonance frequencies, transistors (Q1, Q2) which generate negative resistance by base-collector connection with the common emitter, and a current source (I1) which decides a circuit current value, a double-wave output is extracted from the emitter terminals of the transistors (Q1, Q2).

## Description

### Technical Field

The present invention relates to an oscillator to be used in various kinds of radio apparatuses, communication apparatuses, measuring instruments, and so forth.

### Background Art

Heretofore, incorporation of various kinds of microwave band oscillators into integrated circuits has been implemented in order to achieve small, low-cost radio apparatuses. While there are a variety of circuit types, a cross type oscillator, in which negative resistance can be obtained by transistor base-collector connection with a common emitter, is particularly used for a number of reasons, including the fact that feedback capacitance is not necessary, and phase noise characteristics are better than those of a ring oscillator used in digital circuits.

A conventional oscillator is described below.

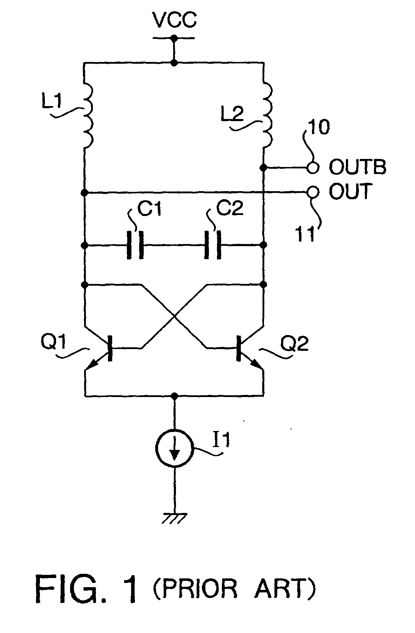

FIG.1 shows the configuration of a conventional oscillator. In FIG.1, L1 and L2 are spiral inductors that can be incorporated in an integrated circuit, C1 and C2 are resonance capacitors, Q1 and Q2 are transistors with base-collector connection with a common emitter, I1 is a current source that decides the current value of the circuit, and 10 and 11 are negative-phase and positive-phase output terminals for outputting oscillator output to external circuitry. Power supply voltage VCC is applied to one side of inductors L1 and L2.

The operation of an oscillator with the above configuration will now be described.

First, the circuit current value is decided by current source I1, and transistors Q1 and Q2 generate negative resistance at the oscillation frequency in accordance with this current value. The oscillation frequency of the circuit is decided by the resonance of inductors L1 and L2 and resonance capacitors C1 and C2, and oscillation is maintained through cancellation of the loss of inductors L1 and L2 and resonance capacitors C1 and C2 by the aforementioned negative resistance.

As the emitters of transistors Q1 and Q2 are connected, these transistors perform differential operation, and dual-phase output is obtained from negative-phase output terminal 10 and positive-phase output terminal 11.

However, with this kind of conventional configuration, the fact that the oscillation frequency is decided by resonance circuit inductors and resonance capacitors means that, particularly in frequency bands of 3 GHz and above, an inductance value of 1 nH or less is required. There is a problem in that, if inductor values becomes too small in an integrated circuit, it becomes difficult to maintain precision and Q values, and this leads to degradation of yield and phase noise.

### Disclosure of Invention

It is an object of the present invention to implement an oscillator with excellent yield and phase noise characteristics, that makes it possible to configure a cross type oscillator at a frequency that is half the desired frequency.

This obj ect is achieved by taking double-wave output from the transistor emitter terminal in a cross type oscillator composed of spiral inductors and resonance capacitors that decide resonance frequencies, transistors that generate negative resistance by base-collector connection with a common emitter, and a current source that decides the circuit current value.

### Brief Description of Drawings

FIG.1 is a connection diagram showing the configuration of a conventional oscillator;
FIG.2 is a connection diagram showing the configuration of an oscillator according to Embodiment 1 of the present invention;
FIG.3 is a connection diagram showing the configuration of an oscillator according to Embodiment 2 of the present invention;
FIG.4 is a connection diagram showing the configuration of an oscillator according to Embodiment 3 of the present invention;
FIG.5 is a connection diagram showing the configuration of an oscillator according to Embodiment 4 of the present invention;
FIG.6 is a connection diagram showing the configuration of an oscillator according to Embodiment 5 of the present invention; and
FIG.7.is a connection diagram showing the configuration of an oscillator according to Embodiment 6 of the present invention.

### Best Mode for Carrying out the Invention

With reference now to the accompanying drawings, embodiments of the present invention will be explained in detail below.

### (Embodiment 1)

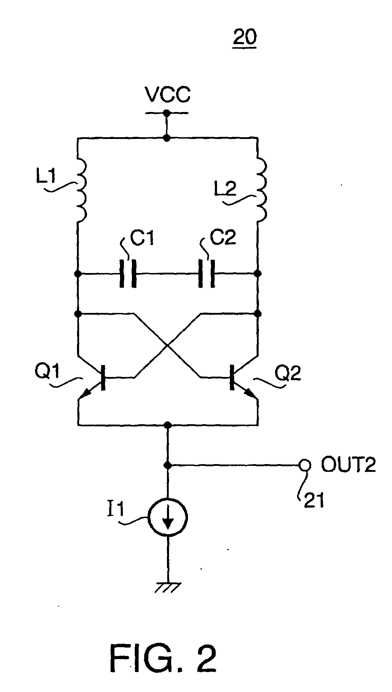

FIG.2, in which parts identical to those in FIG.1 are assigned the same codes as in FIG.1, shows the configuration of an oscillator according to Embodiment 1 of the present invention. Descriptions of parts corresponding to those in FIG.1 are omitted here.

In an oscillator 20 according to this embodiment, an output terminal 21 is connected to the emitter of transistors Q1 and Q2 that have a common emitter, and the oscillation output of oscillator 20 is extracted via that output terminal 21.

The operation of oscillator 20 according to this embodiment will now be described.

First, the circuit current value is decided by current source I1, and transistors Q1 and Q2 generate negative resistance at the oscillation frequency in accordance with this current value. The oscillation frequency of the circuit is decided by the resonance of inductors L1 and L2 and resonance capacitors C1 and C2, and oscillation is maintained through cancellation of the loss of inductors L1 and L2 and resonance capacitors C1 andC2 bythe aforementioned negative resistance. Here, since the emitters of transistors Q1 and Q2 are connected, transistors Q1 and Q2 perform differential operation.

Thus, since the emitters of transistors Q1 and Q2 are connected, cross type oscillator 20 performs differential operation at the fundamental frequency. As a result, transistors Q1 and Q2 operate at 180 degree different phases at both the collector terminal and emitter terminal.

At this time, the emitter terminal is a virtual ground point at the fundamental frequency, and a fundamental signal component does not appear, but double-wave output generated due to distortion of the fundamental output is in-phase at both the collector terminal and emitter terminal of transistors Q1 and Q2. Thus, by providing output terminal 21 at this emitter terminal to extract the output, it is possible to suppress fundamental output and efficiently achieve double-wave output.

Thus, according to this embodiment, by taking output from a transistor emitter terminal that is a fundamental virtual ground point in a cross type oscillator, it is possible to suppress fundamental output and efficiently output a double-wave, thereby enabling a cross type oscillator to be configured at a frequency that is half the desired frequency without using a filter, etc., that is difficult to integrate. As a result, it is possible to implement an oscillator 20 that has excellent yield and phase noise characteristics.

In FIG. 2, current source I1 may of course be replaced by a resistance or by a transistor. Also, transistors Q1 and Q2 are assumed to be bipolar elements, but may be replaced by MOSFETs.

### (Embodiment 2)

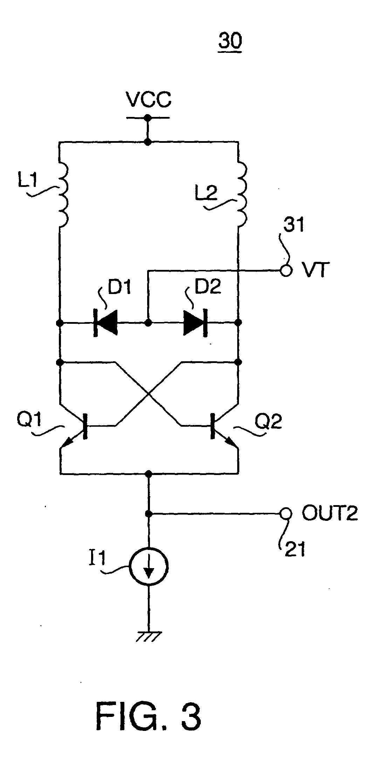

FIG.3, in which parts identical to those in FIG.2 are assigned the same codes as in FIG.2, shows the configuration of an oscillator according to Embodiment 2 of the present invention. Descriptions of parts corresponding to those in FIG.2 are omitted here.

An oscillator 30 according to this embodiment is provided with varactors D1 and D2 whose capacitance value can be varied by application of a DC voltage, and a control voltage input terminal 31 that applies a DC voltage to varactors D1 and D2. Specifically, the anode terminals of varactors D1 and D2 are interconnected, and the cathode terminals are connected to spiral inductors L1 and L2, respectively. Control voltage input terminal 31 is connected to the anode terminals of varactors D1 and D2.

The operation of oscillator 30 according to this embodiment will now be described.

First, the capacitance value of varactors D1 and D2 is decided by the voltage difference between the DC voltage applied from control voltage input terminal 31 and the power supply voltage supplied via spiral inductors L1 and L2. Varactors D1 and D2 form a resonance circuit with inductors L1 and L2, and the frequency can be varied by varying the capacitance value. The operation of other parts is the same as in Embodiment 1, and therefore will not be described here.

Thus, according to this embodiment, by replacing resonance capacitors with varactors D1 and D2, and varying the capacitance value of varactors D1 and D2 by means of a control voltage applied from control voltage input terminal 31, it is possible to implement an oscillator 30 that enables the oscillation frequency to be varied in accordance with the voltage applied from control voltage input terminal 31, in addition to achieving the effect of Embodiment 1.

### (Embodiment 3)

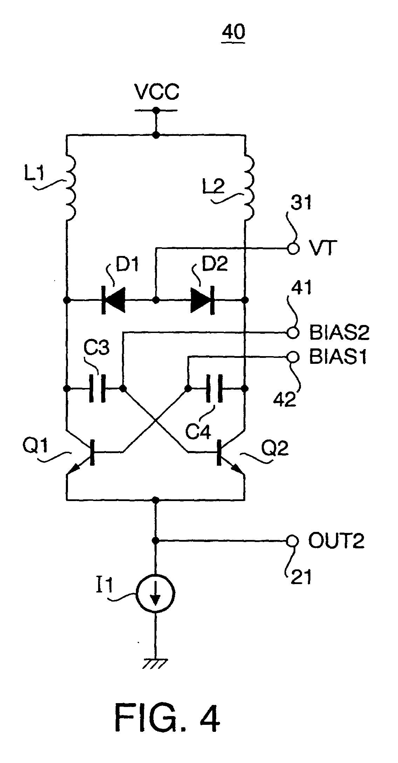

FIG.4, in which parts identical to those in FIG.3 are assigned the same codes as in FIG.3, shows the configuration of an oscillator according to Embodiment 3 of the present invention. Descriptions of parts corresponding to those in FIG.3 are omitted here.

An oscillator 40 according to this embodiment is provided with coupling capacitors C3 and C4 that block a DC voltage, and bias application terminals 41 and 42 that apply a base bias. Specifically, coupling capacitors C3 and C4 are inserted between the base and collector of transistors Q1 and Q2, bias application terminal 41 is connected between coupling capacitor C3 and the base of transistor Q2, and bias application terminal 42 is connected between coupling capacitor C4 and the base of transistor Q1.

The operation of oscillator 40 according to this embodiment will now be described.

Collector-emitter voltages of transistors Q1 and Q2 can be adequately secured by applying base biases independently from bias application terminals 41 and 42. As the securing of a collector-emitter voltage is linked to an improvement in phase noise characteristics, the result is that it is possible to implement a oscillator 40 with excellent phase noise characteristics. The operation of other parts is the same as in Embodiment 2, and therefore will not be described here.

Thus, according to this embodiment, by connecting bases and collectors via two coupling capacitors C3 and C4, and supplying base biases from bias application terminals 41 and 42, it is possible to implement an oscillator 40 that enables collector-emitter voltages of transistors Q1 and Q2 to be secured and phase noise characteristics to be improved, in addition to achieving the effect of Embodiment 2.

### (Embodiment 4)

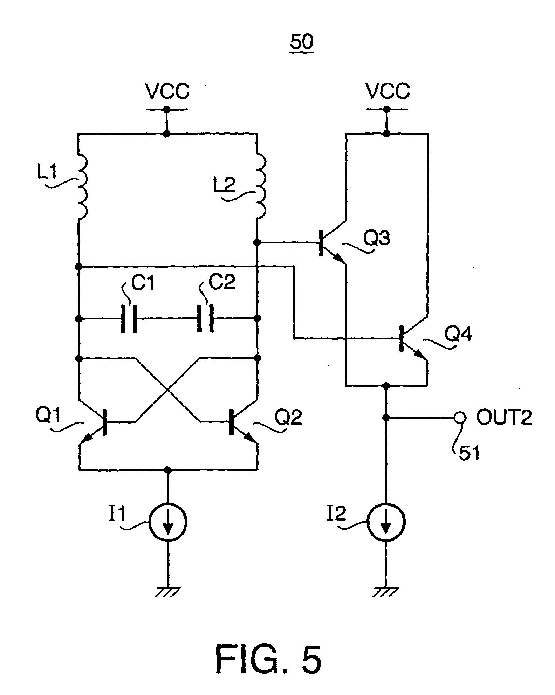

FIG.5, in which parts identical to those in FIG.1 are assigned the same codes as in FIG.1, shows the configuration of an oscillator according to Embodiment 4 of the present invention. Descriptions of parts corresponding to those in FIG.1 are omitted here.

In an oscillator 50 according to this embodiment, transistors Q3 and Q4 forming an emitter follower are connected to the collectors of transistors Q1 and Q2, and a current source I2 that decides the current value of the emitter follower is connected to the emitter of those transistors Q3 and Q4. Also, in oscillator 50, oscillation output is extracted from an output terminal 51 connected to the emitter of transistors Q3 and Q4.

The operation of oscillator 50 according to this embodiment will now be described.

In cross type oscillator 50, there is a fundamental negative phase and double-wave in-phase relationship at the collector terminals of transistors Q1 and Q2. In oscillator 50 according to this embodiment, it is possible to suppress fundamental output and efficiently output a double-wave by in-phase combining of output by the emitter follower composed of transistors Q3 and Q4 and current source I2. Also, as the collector output is of a higher level than the emitter output, output can be obtained at a higher level than in Embodiments 1 through 3.

The operation of other parts is the same as in Embodiment 1, and therefore will not be described here.

Thus, according to this embodiment, by taking double-wave output from two collector terminals and performing in-phase combining by means of an emitter follower circuit in a cross type oscillator composed of spiral inductors L1 and L2 and resonance capacitors C1 and C2 that decide resonance frequencies, transistors Q1 and Q2 that generate negative resistance by base-collector connection with a common emitter, and current source I1 that decides the circuit current value, it is possible to implement an oscillator 50 that enables oscillation output of a significantly higher output level to be obtained, in addition to achieving the effect of Embodiment 1.

### (Embodiment 5)

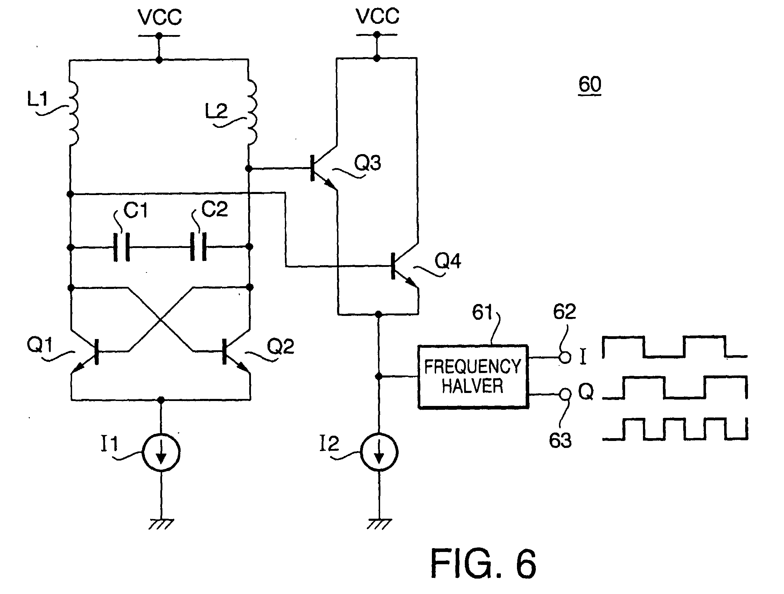

FIG.6, in which parts identical to those in FIG.5 are assigned the same codes as in FIG.5, shows the configuration of an oscillator according to Embodiment 5 of the present invention. Descriptions of parts corresponding to those in FIG.5 are omitted here.

In an oscillator 60 according to this embodiment, a frequency halver 61 is connected to transistors Q3 and Q4 forming an emitter follower. In oscillator 60, oscillation output is obtained from an in-phase signal terminal 62 that extracts an in-phase signal (I) of frequency halver 61, and an orthogonal signal terminal 63 that extracts an orthogonal signal (Q).

The operation of oscillator 60 according to this embodiment will now be described.

Frequency halver 61 can generate a precise 90 degree phase signal by using the rising edge and falling edge of an input signal. That is to say, by inputting a multiplied output to frequency halver 61 and dividing this input, it is possible to generate an in-phase signal (I) and orthogonal signal (Q) in the fundamental frequency. The operation of other parts is the same as in Embodiment 4, and therefore will not be described here.

In this embodiment, a case has been described in which frequency halver 61 is provided at the location of output terminal 51 of Embodiment 4, but this is not a limitation, and a similar effect can also be obtained by providing frequency halver 61 at the location of output terminal 21 in Embodiments 1 through 3.

Thus, according to this embodiment, by dividing the multiplied output obtained by oscillator 20, 30, 40, or 50 according to Embodiments 1 through 4 by means of a frequency halver 61, it is possible to implement an oscillator 60 that enables a 90 degree phase to be obtained in the fundamental oscillation frequency band.

A frequency halver 61 is used to obtain a 90 degree phase, but it is also possible to form a fundamental frequency at half the desired frequency, andperformphase shifting of the multiplied output with a CR phase shifter such as a polyphase filter.

### (Embodiment 6)

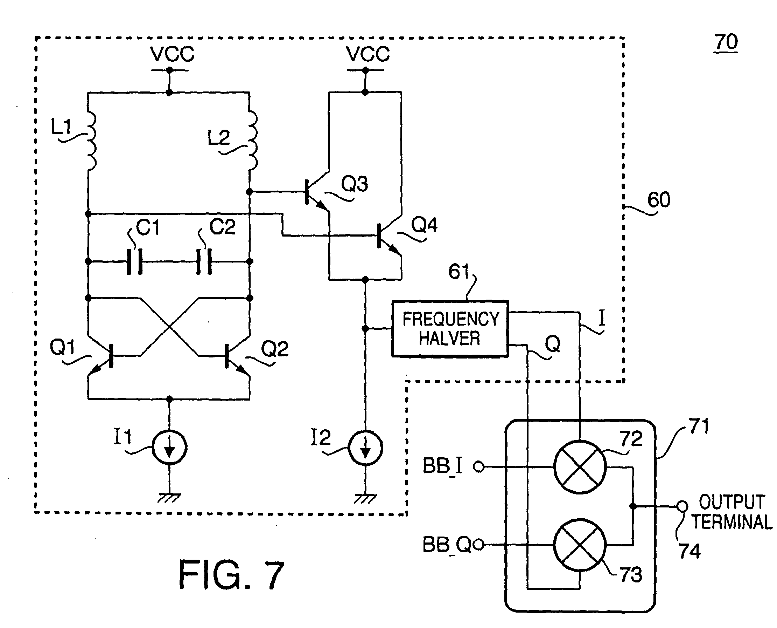

FIG.7, in which parts identical to those in FIG.6 are assigned the same codes as in FIG.6, shows the configuration of a transmission circuit according to Embodiment 6 of the present invention. Transmission circuit 70 is installed in a radio apparatus such as a mobile phone, and performs orthogonal modulation processing on orthogonal baseband signals (BB_I, BB_Q) .

Specifically, an in-phase signal (I) obtained by means of frequency halver 61 is input to multiplication circuit 72 of an orthogonal modulator 71, and an orthogonal signal (Q) obtained by means of frequency halver 61 is input to multiplication circuit 73 of orthogonal modulator 71. Also, orthogonal baseband signal in-phase component (BB_I) is input to multiplication circuit 72, and orthogonal baseband signal in-phase component (BB_Q) is input to multiplication circuit 73. By this means, the orthogonal baseband signal is up-converted to the oscillation frequency generated by oscillator 60 in orthogonal modulator 71, and a transmit signal is obtained from the output terminal 74.

As orthogonal modulation is here carried out in orthogonal modulator 71 on orthogonal baseband signals (BB_I, BB_Q) using the precisely phase-shifted in-phase signal (I) and orthogonal signal (Q) obtained by means of oscillator 60, a transmit signal with excellent phase noise characteristics can be obtained from output terminal 74.

Thus, according to this embodiment, by applying 90 degree phase output of an oscillator according to embodiment 5 to an orthogonal modulator, it is possible to implement transmission circuit 70 that makes it possible to obtain a transmit signal with excellent phase noise characteristics and also to incorporate a transmission circuit including a phase shifter into an integrated circuit.

The descriptions of these embodiments have been limited to a transmitting system for the sake of brevity, but an oscillator according to the present invention can also be applied to an orthogonal demodulator, image rejection mixer, and so forth, in a receiving system.

The present invention is not limited to the above-described embodiments, and various variations and modifications may be possible without departing from the scope of the present invention.

An oscillator according to the present invention has a configuration comprising spiral inductors and resonance capacitors that decide resonance frequencies, first and second transistors that generate negative resistance by base-collector connection with a common emitter, a current source connected to the emitter of the first and second transistors, and an output terminal that is connected to the emitter of the first and second transistors and extracts oscillation output.

According to this configuration, a double-wave can be extracted efficiently from an output terminal while suppressing the fundamental by using a fundamental virtual ground point, thereby making it possible to configure a cross type oscillator at a frequency that is half the desired frequency without using a filter, etc.

An oscillator according to the present invention has a configuration wherein the above-mentioned output terminal extracts an even-numbered high frequency from the above-mentioned emitter.

An oscillator according to the present invention has a configuration wherein the above-mentioned resonance capacitors are replaced by varactors, and a control voltage input terminal is also provided that applies a control voltage to those varactors.

According to this configuration, the oscillation frequency can be varied in accordance with the control voltage from the control voltage input terminal.

An oscillator according to the present invention has a configuration wherein the bases and collectors of the above-mentioned first and second transistors are connected via coupling capacitors, and base biases are supplied to the first and second transistors from bias application terminals.

According to this configuration, it is possible to secure collector-emitter voltages of the first and second transistors and significantly improve phase noise characteristics.

An oscillator according to the present invention has a configuration comprising spiral inductors and resonance capacitors that decide resonance frequencies, first and second transistors that generate negative resistance by base-collector connection with a common emitter, a current source connected to the emitter of the first and second transistors, and an emitter follower circuit that extracts double-wave output from the collector terminals of the first and second transistors and performs in-phase combining thereof.

According to this configuration, the output level can be increased by performing in-phase combining of output using an emitter follower circuit.

An oscillator according to the present invention has a configuration further comprising a frequency divider that forms two signals with different 90 degree phases in the fundamental oscillation frequency band by dividing multiplied output obtained from an output terminal connected to the above-mentioned output terminal.

An oscillator according to the present invention has a configuration further comprising a frequency divider that forms two signals with different 90 degree phases in the fundamental oscillation frequency band by dividing multiplied output that has undergone in-phase combining by the above-mentioned emitter follower circuit.

According to these configurations, a precise 90 degree phase can be obtained by using a phase shifting circuit that employs a frequency divider, without newly using a multiplier.

A transmission circuit according to the present invention has a configuration wherein two signals with different 90 degree phases obtained by means of an above-described oscillator are used in an orthogonal modulator.

According to this configuration, it is possible to obtain a transmit signal with excellent phase noise characteristics, and also to incorporate a transmission circuit including a phase shifter into an integrated circuit.

A radio apparatus according to the present invention has a configuration comprising an above-described oscillator.

According to this configuration, a small radio apparatus can be achieved by integration of the transmission circuit.

As described above, according to the present invention an oscillator with excellent yield and phase noise characteristics can be implemented by extracting fundamental oscillation frequency double-wave output from the emitter of a cross type oscillator.

This application is based on Japanese Patent Application No.2001-296857 filed on September 27, 2001, entire contents of which are expressly incorporated by reference herein.

### Industrial Applicability

The present invention is applicable to various kinds of radio apparatuses, communication apparatuses, measuring instruments, and so forth.

## Claims

1. An oscillator comprising:
spiral inductors and resonance capacitors that decide resonance frequencies;
first and second transistors that generate negative resistance by base-collector connection with a common emitter;
a current source connected to said emitter of said first and second transistors; and
an output terminal that is connected to said emitter of said first and second transistors and extracts oscillation output.

2. The oscillator according to claim 1, wherein said output terminal extracts an even-numbered high frequency from said emitter.

3. The oscillator according to claim 1, wherein said resonance capacitors are replaced by varactors, and further comprising a control voltage input terminal that applies a control voltage to those varactors.

4. The oscillator according to claim 1, wherein bases and collectors of said first and second transistors are connected via coupling capacitors, and base biases are supplied to said first and second transistors from bias application terminals.

5. An oscillator comprising:
spiral inductors and resonance capacitors that decide resonance frequencies:
first and second transistors that generate negative resistance by base-collector connection with a common emitter;
a current source connected to said emitter of said first and second transistors; and
an emitter follower circuit that extracts double-wave output from collector terminals of said first and second transistors and performs in-phase combining thereof.

6. An oscillator according to claim 1, further comprising a frequency divider that forms two signals with different 90 degree phases in a fundamental oscillation frequency band by dividing multiplied output obtained from an output terminal connected to said output terminal.

7. An oscillator according to claim 5, further comprising a frequency divider that forms two signals with different 90 degree phases in a fundamental oscillation frequency band by dividing multiplied output that has undergone in-phase combining by said emitter follower circuit.

8. A transmission circuit wherein two signals with different 90 degree phases obtained by means of the oscillator according to claim 6 are used in an orthogonal modulator.

9. A transmission circuit wherein two signals with different 90 degree phases obtained by means of the oscillator according to claim 7 are used in an orthogonal modulator.

10. A radio apparatus that has an oscillator, said oscillator comprising:
spiral inductors and resonance capacitors that decide resonance frequencies;
first and second transistors that generate negative resistance by base-collector connection with a common emitter;
a current source connected to said emitter of said first and second transistors; and
an output terminal that is connected to said emitter of said first and second transistors and extracts oscillation output.
